# EUROPEAN PATENT SPECIFICATION

(11) **EP 4 518 458 B1**
(45) Date of publication and mention of the grant of the patent: **08.04.2026**
(21) Application number: 24196786.8
(22) Date of filing: 27.08.2024
(51) Int. Cl.: H04W 52/36, H01Q 1/24, H01Q 21/28, H04B 1/3827, G01S 7/00, G01S 13/08

(54) **ANTENNA MODULE AND ELECTRONIC DEVICE INCLUDING THE SAME**
ANTENNENMODUL UND ELEKTRONISCHE VORRICHTUNG DAMIT
MODULE D'ANTENNE ET DISPOSITIF ÉLECTRONIQUE LE COMPRENANT

(30) Priority: 01.09.2023 KR 20230116528
(43) Date of publication of application: 05.03.2025
(73) Proprietor: Samsung Electronics Co., Ltd, Suwon-si, Gyeonggi-do 16677 (KR)
(72) Inventor: LEE, Woncheol, Suwon-si 16677 (KR); YANG, Doohyun, Suwon-si 16677 (KR); LEE, Youngki, Suwon-si 16677 (KR); CHOI, Dooseok, Suwon-si 16677 (KR); RYOO, Jeongki, Suwon-si 16677 (KR); HUR, Joonhoi, Suwon-si 16677 (KR)
(74) Representative: Marks & Clerk LLP

(56) References cited:
- US-A1- 2022 149 958

## Description

### Technical Field

Embodiments of the present disclosure described herein relate to an antenna module and an electronic device including the same.

### Discussion of Related Art

When an electronic device operates for wireless communication with an external device, the electronic device emits an electromagnetic (EM) wave (EM signal). The emitted electromagnetic wave may be absorbed by the human body and may cause harmful effects if the EM power is too high. Accordingly, organizations in each country have introduced evaluation standards such as a specific absorption rate (SAR), a power density (PD), and a total exposure ratio (TER) and may regulate the EM wave emitted from the electronic device so as not to exceed thresholds prescribed by the standards.

The specific absorption rate (SAR), which defines the rate at which electromagnetic waves are absorbed by the human body, may be applied to signals in the frequency band of 6 GHz or lower; the power density (PD) and the total exposure ratio (TER) may be applied to signals in the frequency band of 6 GHz or higher.

Meanwhile, to cope with the increasing demand for wireless data traffic following the commercialization of the 4G (4th generation) communication system, efforts are being made to develop an improved 5G (5th generation) communication system or a pre-5G communication system. To implement a high data transfer rate, the 5G communication system is being considered for implementation in an ultra-high frequency (mmWave) band (e.g., about 20 GHz to about 300 GHz).

Accordingly, electronic devices may be designed to satisfy the regulations associated with the specific absorption rate (SAR), the power density (PD), and the total exposure rate (TER) when performing communication using the 5G communication system.

US2022149958A1 describes an electronic device using a millimeter wave including a communication circuit and at least one processor. The at least one processor can be configured to: control the communication circuit so that a first millimeter wave signal is output at a first strength; use the communication circuit so that the first millimeter wave signal receives a first reflection signal reflected by an object; confirm whether the object is positioned within a first distance from the electronic device; determine the strength of a second millimeter wave signal to be a second strength corresponding to a second distance between the electronic device and the object, the second distance being shorter than the first distance; and control the communication circuit so that the second millimeter wave signal is output at the determined second strength.

### SUMMARY

Embodiments of the present disclosure provide an antenna module including an antenna group for obtaining location information of an external object and an antenna group for transmitting an RF signal with a transmit power corresponding to the location information.

According to an aspect of the present disclosure, an antenna module is as defined in claim 1.

According to an aspect of the present disclosure, a wireless communication method is as defined in claim 11.

According to an example of the present disclosure, an electronic device may include a housing forming at least a portion of an exterior of the electronic device, an antenna module formed inside the housing, and a processor. The antenna module may include a printed circuit board, a first antenna group that includes a first sensing antenna and a second sensing antenna disposed on a first surface of the printed circuit board and transmits and receives a first signal, and a second antenna group that includes a plurality of antenna elements disposed on the first surface between the first sensing antenna and the second sensing antenna. The processor may obtain information about a distance between an external object and the antenna module, based on the first signal transmitted and received through the first antenna group, and may cause a second signal to be transmitted through the second antenna group with a first transmit power less than or equal to a first maximum power set to correspond to the first distance, when the external object is within a first distance from the antenna module.

At least some of the above and other features of the invention are set out in the claims.

### BRIEF DESCRIPTION OF THE FIGURES

The above and other aspects and features of the present disclosure will become apparent by describing in detail embodiments thereof with reference to the accompanying drawings.
FIG. 1 is a block diagram illustrating an antenna module according to an embodiment of the present disclosure.
FIG. 2A is a perspective view of an antenna module sensing an external object, when viewed from one side, according to an embodiment.
FIG. 2B is a plan view illustrating an antenna module of FIG. 2A.
FIG. 2C is a perspective view of an antenna module of FIG. 2A, when viewed from another side.
FIG. 3A illustrates an example of the cross section of an antenna module taken along line A-A' of FIG. 2A.
FIG. 3B illustrates another example of the cross section of an antenna module taken along line A-A' of FIG. 2A.
FIG. 3C illustrates a first antenna group and a second antenna group of an antenna module of FIG. 3B, in relation to respective ground planes for reflecting signals.
FIG. 4 illustrates a configuration in which an antenna module according to an embodiment senses an external object within a first distance from the antenna module.
FIG. 5 is a flowchart illustrating an operation in which an antenna module controls a transmit power when an external object is within a first distance from the antenna module, according to an embodiment.
FIG. 6A illustrates a configuration in which an antenna module according to an embodiment senses an external object within a second distance from the antenna module.
FIG. 6B is a flowchart illustrating an operation in which an antenna module of FIG. 6A controls a transmit power when an external object is within a second distance from the antenna module, according to an embodiment.
FIG. 7A illustrates a configuration in which an antenna module according to an embodiment senses an external object present between a first distance and a third distance from the antenna module.
FIG. 7B is a flowchart illustrating an operation in which an antenna module of FIG. 7A controls a transmit power when an external object is present between a first distance and a third distance from the antenna module.
FIG. 8A illustrates an antenna module further including a third sensing antenna, according to another embodiment.
FIG. 8B illustrates a configuration in which an antenna module of FIG. 8A obtains information about an angle formed by an external object and the antenna module by using a first antenna group.
FIG. 9 illustrates a configuration in which an antenna module included in an electronic device according to an embodiment transmits a signal with a transmit power corresponding to a distance from an external object.
FIG. 10 is a block diagram illustrating an antenna module according to an embodiment of the present disclosure.

### DETAILED DESCRIPTION

Below, embodiments of the present disclosure will be described in detail and clearly to such an extent such that one of ordinary skill in the art may readily carry out these and other embodiments of the present disclosure.

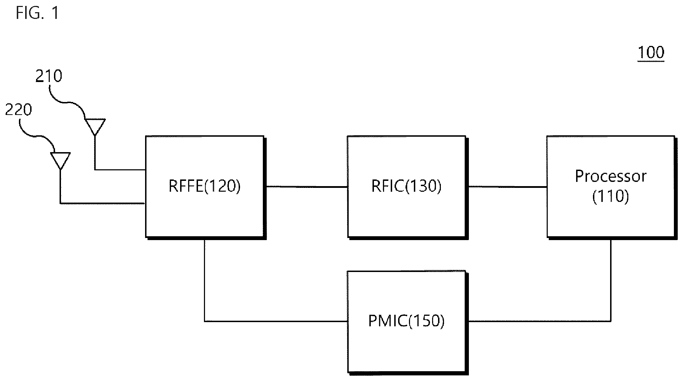

FIG. 1 is a block diagram illustrating an antenna module according to an embodiment of the present disclosure.

Referring to FIG. 1, an antenna module 100 according to an embodiment may include a first antenna group 210, a second antenna group 220, a radio frequency front end (RFFE) 120, a radio frequency integrated circuit (RFIC) 130, a power management integrated circuit (PMIC) 150, and a processor 110. The antenna module 100 may operate as both a radar and a transceiver.

The antenna module 100 may include the first antenna group 210 and the second antenna group 220 that transmit and/or receive signals in different frequency bands.

In detail, the antenna module 100 may include the first antenna group 210 that transmits and receives a first signal in a first frequency band. Also, the antenna module 100 may include the second antenna group 220 that transmits and receives a second signal in a second, different frequency band.

Herein, the first signal may be referred to as a "radar signal" for obtaining location information of an external object adjacent (proximate) to the antenna module 100. For example, the first signal may be a radar signal with a frequency of about 60 GHz.

The frequency of the second signal may vary from embodiment to embodiment. The second signal may be referred to as a "radio frequency (RF) signal" for wireless communication in a specified frequency band. For example, the second signal may be a mmWave signal (herein considered a type of an RF signal) within a frequency band of about 28 GHz.

In other embodiments, the second signal has a frequency lower than that of a mmWave signal. For example, the second signal may be referred to as a "long-term evolution (LTE) signal" having a frequency within a band of about 700 MHz. In still other embodiments, the first and second signals fall within other frequency bands.

According to an embodiment, the first antenna group 210 and the second antenna group 220 may be part of (e.g., formed in) a single printed circuit board. Also, the first antenna group 210 and the second antenna group 220 may be electrically connected to the single RFFE 120 and the single RFIC 130.

Thus, the antenna module 100 may transmit/receive signals in different frequency bands by using the first antenna group 210 and the second antenna group 220 that are formed in the single printed circuit board.

Accordingly, the antenna module 100 according to the present disclosure may be called an antenna device, a wireless communication device, or a transceiver that includes the first antenna group 210 and the second antenna group 220.

The antenna module 100 may include the RFFE 120 that receives an RF signal through the first antenna group 210 and/or the second antenna group 220.

According to an embodiment, the RFFE 120 may perform pre-processing with respect to the signal received through the first antenna group 210 and/or the second antenna group 220. For example, the RFFE 120 may pre-process the RF signal received through the second antenna group 220.

To this end, the RFFE 120 may include at least one of a phase shifter connected to the first antenna group 210 and the second antenna group 220, a band pass filter, and a switching circuit.

The antenna module 100 may include the RFIC 130 connected to the RFFE 120. The RFIC 130 may convert a baseband signal into an RF signal in a transmitting path and/or convert an RF signal into a baseband signal in a receiving path.

For example, in the case of receiving a signal, the RFIC 130 may convert an RF signal pre-processed through the RFFE 120 into a baseband signal so as to be processed by the processor 110.

Also, for example, in the case of transmitting a signal, the RFIC 130 may convert a baseband signal generated by the processor 110 into an RF signal in the Sub6 band (e.g., about 6 GHz or lower) that is used in a second network (e.g., a 5G network).

In another example, in the case of transmitting a signal, the RFIC 130 may convert a baseband signal generated by the processor 110 into an RF signal in the 5G Above6 band (e.g., about 6 GHz to about 60 GHz) to be used in a third network (e.g., a 5G network).

In another example, in the case of transmitting a signal, the RFIC 130 may convert a baseband signal generated by the processor 110 into an RF signal of about 700 MHz to about 3 GHz, where the RF signal is used in a first network (e.g., a legacy network).

The antenna module 100 may include the processor 110 electrically connected to the RFIC 130 and the PMIC 150. The processor 110 may be coupled to each of the first antenna group 210 and the second antenna group through the RFIC 130 and the RFFE 120.

The processor 110 may execute, for example, software (e.g., a program) to control at least another component (e.g., the RFIC 130 or the PMIC 150) of the antenna module 100 and may perform various data processing or operations. The processor 110 may include a central processing unit or a microprocessor and may control an overall operation of the antenna module 100. Accordingly, below, operations that are performed by the antenna module 100 may be understood as being performed under control of the processor 110.

The processor 110 may include an algorithm for controlling at least some of the RFIC 130 or the PMIC 150. For example, the algorithm may be a software code programmed in the processor 110. In another example, the algorithm may be a hard code hard-coded in the processor 110, but the present disclosure is not limited thereto.

The processor 110 may control the RFIC 130 and the PMIC 150 depending on the algorithm such that a target transmit power is provided to each of the first antenna group 210 and the second antenna group 220.

Under control of the processor 110, the PMIC 150 may supply power to the first antenna group 210 and the second antenna group 220. To this end, under control of the processor 110, the PMIC 150 may provide the transmit power to the first antenna group 210 and the second antenna group 220 through the RFFE 120.

For example, under control of the processor 110, the PMIC 150 may provide the first antenna group 210 with the transmit power for transmitting the first signal. Also, under control of the processor 110, the PMIC 150 may provide the second antenna group 220 with the transmit power for transmitting the second signal.

As such, the processor 110 may be said herein to "transmit and/or receive signals" in specified frequency bands using the first antenna group 210 and/or the second antenna group 220.

Accordingly, the processor 110 according to the present disclosure may be called a communication processor (CP).

The processor 110 may obtain information about a distance between an external object and the antenna module 100 through the first antenna group 210. For example, the processor 110 may transmit and receive the radar signal through the first antenna group 210 and may measure a distance from the antenna module 100 to an external object close to the antenna module 100.

In addition, the processor 110 may control the transmit power for the second antenna group 220 based on the obtained distance information.

In this regard, when the external object is within a given distance from the antenna module 100, the processor 110 may provide the second antenna group 220 with the transmit power that is less than or equal to a maximum power set depending on a distance.

In this case, for example, the maximum power set depending on a distance may be set to satisfy the standards associated with at least some of the specific absorption rate (SAR), the power density (PD), and the total exposure ratio (TER).

For instance, the maximum power according to a distance may be understood as an allowable power that is set such that the influence that an electromagnetic wave emitted by the antenna module 100 has on the human body adjacent to the antenna module 100 is less than a reference value.

For example, when the external object is within a first distance from the antenna module 100, the processor 110 may transmit the second signal through the second antenna group 220 with a first transmit power that is less than or equal to a first maximum power set to correspond to the first distance.

Referring to the above components, the processor 110 according to an embodiment may determine a distance between the external object and the antenna module 100 through the first antenna group 210.

In addition, based on the distance between the external object and the antenna module 100, the processor 110 may transmit the second signal through the second antenna group 220 with the transmit power that is less than or equal to the maximum power set to correspond to the distance.

Accordingly, the antenna module 100 according to the present disclosure may control the transmit power of an antenna for wireless communication within a range in which the standard associated with the human body adjacent to the antenna module 100 is satisfied.

As such, the antenna module 100 according to the present disclosure may improve power efficiency for wireless communication.

Also, referring to the above components, the antenna module 100 may include the first antenna group 210 that is used to obtain location information of an external object and the second antenna group 220 that is used to transmit a wireless communication signal with the transmit power according to the location information.

As such, the antenna module 100 according to the present disclosure may be implemented with minimized area (or size).

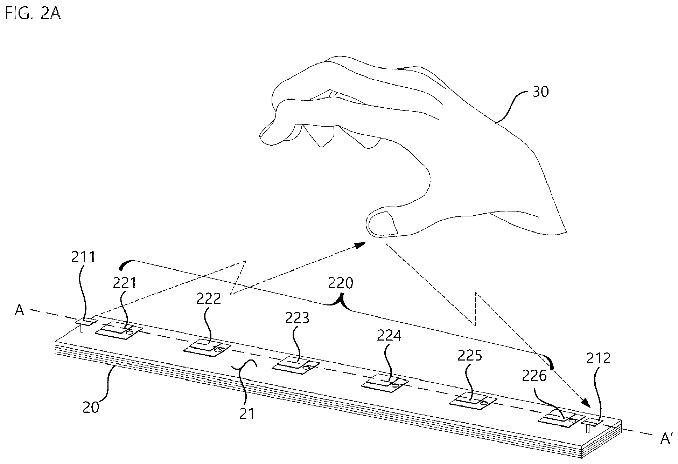

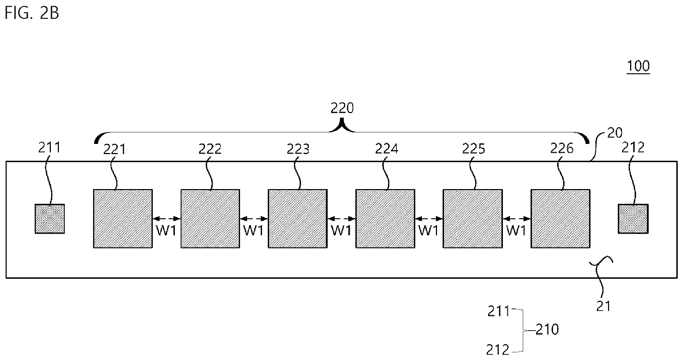

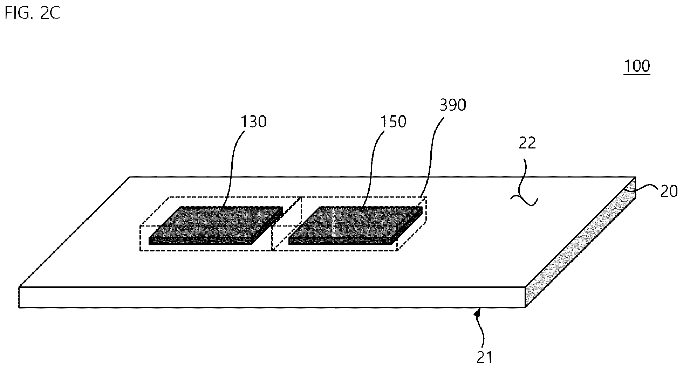

FIG. 2A is a perspective view of an antenna module sensing an external object, when viewed from one side, according to an embodiment. FIG. 2B is a plan view illustrating an antenna module of FIG. 2A. FIG. 2C is a perspective view of an antenna module of FIG. 2A, when viewed from an opposite side.

Referring to FIGS. 2A, 2B, and 2C together, the antenna module 100 according to an embodiment may include a printed circuit board 20, the first antenna group 210, the second antenna group 220, the RFIC 130, and the PMIC 150. According to another embodiment, at least some of the above components may be omitted, or at least two of the components may be integrally formed. Also, selectively, the antenna module 100 may further include a shielding member 390.

Referring to FIG. 2A, the printed circuit board 20 may include a plurality of conductive layers and a plurality of non-conductive layers, and the conductive layers and the non-conductive layers may be alternately stacked.

The printed circuit board (PCB) 20 may provide an electrical connection between various electronic components, which are disposed on the printed circuit board 20 and/or externally of the PCB 20, by using wires and conductive vias formed in conductive layers.

The first antenna group 210 may include a first sensing antenna 211 and a second sensing antenna 212 that are used to transmit and receive the first signal.

In detail, the first antenna group 210 may include the first sensing antenna 211 and the second sensing antenna 212 that are disposed to transmit and receive the first signal and to obtain location information of an external object 30 adjacent to the antenna module 100.

For example, the processor 110 may transmit the first signal through the first sensing antenna 211 and may receive the first signal through the second sensing antenna 212.

According to an embodiment, the first sensing antenna 211 and the second sensing antenna 212 may be disposed on a first surface 21 of the printed circuit board 20. Also, the first sensing antenna 211 and the second sensing antenna 212 may be disposed on the first surface 21 of the printed circuit board 20 in a manner spaced from each other.

The second antenna group 220 may include a plurality of antenna elements 221, 222, 223, 224, 225, and 226 disposed to form a directional beam.

Herein, for example, the second antenna group 220 may include the plurality of antenna elements 221-226 arranged in a one by six matrix at given intervals W1.

In another example, the second antenna group 220 may include the first antenna element 221 to the fourth antenna element 224 arranged in a one by four matrix.

However, the number and arrangement of antenna elements included in the second antenna group 220 are not limited to the above examples.

According to an embodiment, the plurality of antenna elements 221-226 may be formed on the first surface 21 of the printed circuit board 20. According to another embodiment, the second antenna group 220 may be formed inside the printed circuit board 20.

Referring to FIG. 2B, the plurality of antenna elements 221- 226 may be on the first surface 21 in a region disposed between the first sensing antenna 211 and the second sensing antenna 212.

Here, the plurality of antenna elements 221- 226 may be disposed between the first sensing antenna 211 and the second sensing antenna 212 at the given intervals W1.

For example, the first sensing antenna 211, the second sensing antenna 212, and the plurality of the plurality of antenna elements 221- 226 may be on the first surface 21 arranged in a one by eight matrix, but the present disclosure is not limited thereto.

The first sensing antenna 211 and the second sensing antenna 212 may be formed to be spaced from each other with the plurality of antenna elements 221- 226 interposed therebetween.

Accordingly, while the processor 110 transmits the first signal through the first sensing antenna 211 and receives the first signal through the second sensing antenna 212, an undesirable return current (e.g., due to surface waves) that flows from the first sensing antenna 211 to the second sensing antenna 212 may be minimized.

Thus, the antenna module 100 according to the present disclosure may improve the isolation between the first sensing antenna 211 and the second sensing antenna 212.

As such, the antenna module 100 according to the present disclosure may improve the performance of the first antenna group 210 that is used to determine the distance between the external object 30 and the antenna module 100.

According to another embodiment, at least one of the first sensing antenna 211 and the second sensing antenna 212 may be disposed between the plurality of antenna elements 221-226.

For example, the first sensing antenna 211 may be disposed between the first antenna element 221 and the second antenna element 222, and the second sensing antenna 212 may be disposed adjacent to the sixth antenna element 226.

In another example, the first sensing antenna 211 may be disposed between the first antenna element 221 and the second antenna element 222, and the second sensing antenna 212 may be disposed between the fifth antenna element 225 and the sixth antenna element 226.

However, the placement of each of the first sensing antenna 211, the second sensing antenna 212, and the plurality of antenna elements 221- 226 is not limited to the above examples. In some examples, at least one of the plurality of antenna elements 221 - 226 is provided between the first sensing antenna 211 and the second sensing antenna 212.

Also, according to an embodiment, the second antenna group 220 may include a plurality of antenna arrays (e.g., a dipole antenna array and/or a patch antenna array), whose shapes or types are identical or different.

Referring to FIG. 2C, the RFIC 130 may be disposed on a second surface 22 of the printed circuit board 20. Here, the RFIC 130 may be disposed on the second surface 22 of the printed circuit board 20, which is parallel to and opposite the first surface 21.

According to an embodiment, in the case of transmitting a signal, the RFIC 130 may convert a baseband signal obtained from the processor 110 into an RF signal in a specified band. Also, in the case of receiving a signal, the RFIC 130 may convert an RF signal received through the second antenna group 220 into a baseband signal, which is transferred to the processor 110.

According to another embodiment, in the case of transmitting a signal, the RFIC 130 may up-convert an IF signal (e.g., about 9 GHz to about 11 GHz) obtained from an intermediate frequency integrated circuit (IFIC) into an RF signal in a selected band. In the case of receiving a signal, the RFIC 130 may down-convert an RF signal obtained through the second antenna group 220 so as to be converted into an IF signal, and may provide the IF signal to an IFIC.

The PMIC 150 may be disposed on the second surface 22 of the printed circuit board 20. The PMIC 150 may be supplied with a voltage from the processor 110 (or a power source) and may provide a power necessary for various components (e.g., the RFIC 130, the first antenna group 210, or the second antenna group 220) on the antenna module 100.

The shielding member 390 may be disposed on a portion (e.g., the second surface 22) of the printed circuit board 20 such that at least one of the RFIC 130 or the PMIC 150 is electromagnetically shielded. According to an embodiment, the shielding member 390 may include a shield can.

Referring to the above components, the antenna module 100 may include the first sensing antenna 211, the second sensing antenna 212, and the plurality of antenna elements 221-226 disposed between the first sensing antenna 211 and the second sensing antenna 212.

Herein, the first sensing antenna 211, the second sensing antenna 212, and the plurality of antenna elements 221- 226 may be disposed on/in the single printed circuit board 20.

As such, the antenna module 100 according to the present disclosure may be implemented with a minimized area (or size).

According to an embodiment, the processor 110 may be electrically connected to the RFIC 130, the PMIC 150, the first antenna group 210, and the second antenna group 220.

The processor 110 may control the RFIC 130 and the PMIC 150 such that the first signal is transmitted and received through the first antenna group 210. As such, the processor 110 may identify a distance from the external object 30 to the antenna module 100.

The external object 30 is an object that reflects a radar signal, and may be a portion (e.g., a hand or a head) of the human body, but the present disclosure is not limited thereto.

Also, the processor 110 may control the RFIC 130 and the PMIC 150 such that the second signal is transmitted through the second antenna group 220. To this end, the processor 110 may "transmit" the second signal through the second antenna group 220 with a transmit power that is determined based on the distance identified through the first antenna group 210. (As noted above, herein, the phrase "processor transmits a signal through an antenna" or like form may be understood to mean that the processor outputs a digital signal or a baseband signal, and other transceiver components coupled between the processor and antenna modulate an RF / mm wave carrier to generate a modulated RF / mm wave signal which is transmitted through the antenna.)

Accordingly, the antenna module 100 according to the present disclosure may improve power efficiency for wireless communication within a range in which the standard associated with the human body adjacent to the antenna module 100 is satisfied.

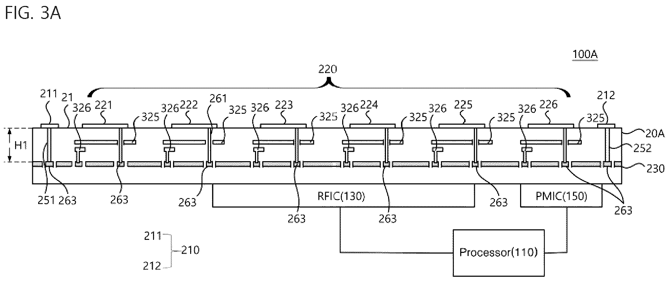

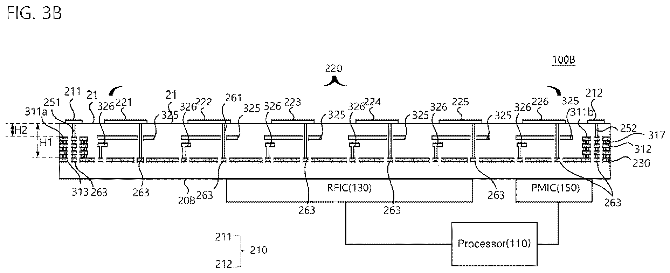

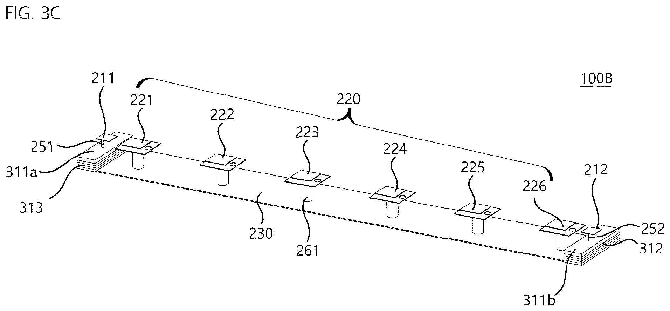

FIG. 3A illustrates an example of the cross-sectional structure of an antenna module taken along line A-A' of FIG. 2A. FIG. 3B illustrates another example of the cross -sectional structure of an antenna module taken along line A-A' of FIG. 2A. FIG. 3C illustrates a first antenna group and a second antenna group of an antenna module of FIG. 3B, in relation to respective ground planes for reflecting signals from the antennas.

Referring to FIGS. 3A to 3C together, an antenna module 100A/100B (or a printed circuit board 20A/20B) according to an embodiment may include a ground plane 230 for reflecting signal energy to / from the first antenna group 210 and/or the second antenna group 220. In the antenna module 100A of FIG. 3A, the ground plane 230 may serve as a ground plane for each of the first antenna group 210 and the second antenna group 220. In the antenna module 100B of FIGS. 3B and 3C, the ground plane 230 may serve as a ground plane for just the second antenna group 220.

The ground plane 230 according to an embodiment may be formed in one of a plurality of layers present inside the printed circuit board 20A/20B. In this regard, the ground plane 230 may be formed in a layer, which is spaced from the first surface 21 by a first height H1, from among the plurality of layers present inside the printed circuit board 20A/20B.

Each of the plurality of antenna elements 221, 222, 223, 224, 225, and 226 included in the second antenna group 220 may be connected to a respective conductive pad 263 at the same height as the ground plane 230, through a respective conductive via 261 penetrating the printed circuit board 20A/20B. Each conductive pad 263 may be located within a respective opening in the ground plane 230, and thereby annularly isolated from the ground plane 230 as illustrated in the cross-sectional view. An inner conductor (not shown) of a transmission line connected to the RFIC 130 or the RFFE 120 may be connected to each conductive pad 263, and an outer conductor of the transmission line may be connected to the ground plane 230 to form a suitable antenna feed, as known in the antenna art. Each of the antenna elements 221 to 226 may thus be driven by a "probe feed" or other suitable feed structure. Alternatively, the antenna elements 221 to 226 are each driven by an electromagnetic coupling scheme.

Also, in the antenna module 100A of FIG. 3A, the first sensing antenna 211 and the second sensing antenna 212 may each be connected to a respective conductive pad 263 (located within an opening in the ground plane 230) at the same height as the ground plane 230, through conductive vias 251 and 252, respectively.

In this regard, signal energy to/from the first sensing antenna 211 may be reflected from a corresponding portion of the ground plane 230 below the first sensing antenna 211. Also, signal energy to/from the second sensing antenna 212 may be reflected from a corresponding portion of the ground plane 230 below the second sensing antenna 212.

Meanwhile, the first sensing antenna 211 and the second sensing antenna 212 may be disposed spaced from each other with the plurality of antenna elements 221, 222, 223, 224, 225, and 226 interposed therebetween.

For example, the first sensing antenna 211 may be disposed adjacent to a first end of the first surface 21 of the printed circuit board 20A, which is adjacent to the first antenna element 221. Also, the second sensing antenna 212 may be disposed adjacent to a second end of the first surface 21 of the printed circuit board 20A, which is adjacent to the sixth antenna element 226.

Thus, the first sensing antenna 211 and the second sensing antenna 212 may be respectively disposed adjacent to opposite ends of the second antenna group 220. In addition, a plurality of conductive structures 325 and a plurality of conductive structures 326 within the printed circuit board may be used to radiate signals of frequency distinct from the frequency of signals radiated from the second antenna group 220.

For example, when the second antenna group 220 radiates low-band mmWave signals, a plurality of conductive structures 325, 326 may radiate high-band mmWave signals.

In another example, when the second antenna group 220 radiates high-band mmWave signals, a plurality of conductive structures 325, 326 may radiate low-band mmWave signals.

Referring to the above components, as compared to a conventional case in which the antenna elements 221 to 226 and associated conductive structures 325 and 326 are not present between the first sensing antenna 211 and the second sensing antenna 212, the antenna module 100A may increase an electrical length and an attenuation of undesirable surface waves that may propagate between the first sensing antenna 211 and the second sensing antenna 212 by reflections from the ground plane 230.

As such, the antenna module 100A according to the present disclosure may improve the isolation between the first sensing antenna 211 and the second sensing antenna 212 (as compared to the conventional case).

Also, for example, an electrical connection path from the RFIC 130 to the first sensing antenna 211 and an electrical connection path from the RFIC 130 to the second sensing antenna 212 may have the same electrical length.

As such, the antenna module 100A may minimize a path loss due to an electrical connection path from the RFIC 130 to the first sensing antenna 211 and an electrical connection path from the RFIC 130 to the second sensing antenna 212.

Through the above components, the antenna module 100A may improve the performance of the first antenna group 210 including the first sensing antenna 211 and the second sensing antenna 212.

In other words, the antenna module 100A may improve accuracy of the measured distance between the external object 30 and the antenna module 100A, which is measured through the first antenna group 210.

Referring to FIGS. 3B and 3C, the antenna module 100B differs from the above-described antenna module 100A of FIG. 3A by implementing a unique ground plane structure for each of the first and second sensing antennas 211 and 212. These ground plane structures may further improve isolation between the first and second sensing antennas 211 and 212.

To this end, the printed circuit board 20B may include a first local ground plane 311a spaced from the first surface 21 by a second height H2 less than the first height H1. The first local ground plane 311a may reflect signal energy to/from the first sensing antenna 211 and may surround the first conductive via 251 (the first conductive via 251 may be isolated from the first local ground plane 311a).

Also, the printed circuit board 20B may include a second local ground plane 311b spaced from the first surface 21 by the second height H2 less than the first height H1. The second local ground plane 311b may reflect signal energy to/from the second sensing antenna 212 and may surround the second conductive via 252 in an isolated manner (the second conductive via 252 may be isolated from the first local ground plane 311b).

When viewed in a direction perpendicular to the first surface 21, the first local ground plane 311a may be formed at a location corresponding to at least a portion of the first sensing antenna 211.

Also, when viewed in the direction perpendicular to the first surface 21, the second local ground plane 311b may be formed at a location corresponding to at least a portion of the second sensing antenna 212.

Each of the first and second local ground planes 311a and 311b may be formed, and spaced from, the ground plane 230 by stacked metal layers and interconnects such as metal layers 312 and 313 and interconnects 317 between adjacent metal layers 230, 312, 313 and 311a or 311b

Undesirable surface waves between the first sensing antenna 211 and the second sensing antenna 212 may propagate through an electrical path including the first local ground plane 311a, the ground plane 230, and the second local ground plane 311b.

An electrical length of an electrical path that is formed (with antenna elements 221 to 226 and associated conductive structures 325 and 326 between the first and second sensing antennas) through the first local ground plane 311a, the ground plane 230, and the second local ground plane 311b may be longer than that, and have higher attenuation, of an electrical path that is formed only by the ground plane 230 (and without antenna elements 221 and 226 and conductive structures 325 and 326 between the first and second sensing antennas 211 and 212).

For example, compared to the electrical path formed only by the ground plane 230, the electrical path formed through the first local ground plane 311a, the ground plane 230, and the second local ground plane 311b may further include an electrical length corresponding to two times a height difference (i.e., H1) of the ground plane 230 and the first local ground plane 311a (due to additional reflective paths that surface waves may need to propagate through).

Accordingly, as compared to a conventional design, the antenna module 100B according to an embodiment may increase a propagation path, and attenuation, of surface waves traveling between the first sensing antenna 211 and the second sensing antenna 212.

As such, the antenna module 100B according to the present disclosure may improve the isolation between the first sensing antenna 211 and the second sensing antenna 212.

Referring to the above components, the antenna module 100B may improve the performance of the first antenna group 210 including the first sensing antenna 211 and the second sensing antenna 212.

In other words, the antenna module 100A may improve accuracy of the measured distance between the external object 30 and the antenna module 100A, which is measured through the first antenna group 210.

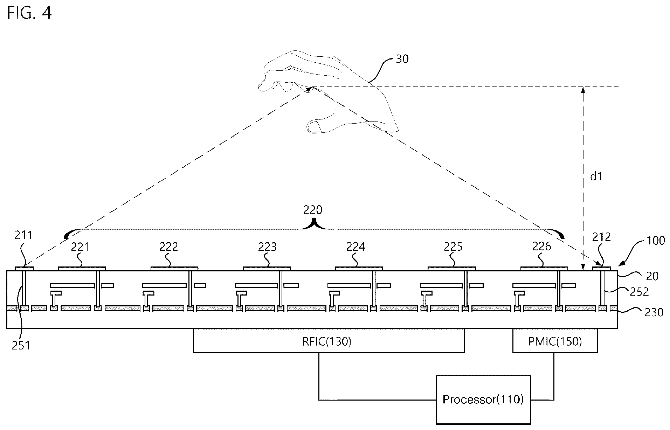

FIG. 4 illustrates a configuration in which an antenna module according to an embodiment senses an external object within a first distance from the antenna module.

Referring to FIG. 4, the processor 110 according to an embodiment may obtain information about a distance between the antenna module 100 and the external object 30 adjacent to the antenna module 100 using the first antenna group 210.

In detail, the processor 110 may determine whether the external object 30 is within a first distance d1 from the antenna module 100, using the first antenna group 210.

According to an embodiment, the processor 110 may transmit the first signal through the first sensing antenna 211. For example, the processor 110 may transmit a radar signal in a 60 GHz band using the first sensing antenna 211.

Also, the processor 110 may receive, through the second sensing antenna 212, the first signal that is transmitted through the first sensing antenna 211 and is then reflected by the external object 30.

The processor 110 may measure a distance between the external object 30 and the antenna module 100, based on the first signal received through the second sensing antenna 212.

For example, the processor 110 may measure the distance between the external object 30 and the antenna module 100, based on the distance between the first sensing antenna 211 and the second sensing antenna 212 and an elapsed time from a point in time when the first signal is transmitted to a point in time when the first signal is received.

In this case, for example, the distance between the external object 30 and the antenna module 100 may be understood as a straight line distance between one point on the external object 30 and one point of the antenna module 100, but the present disclosure is not limited thereto.

The processor 110 may determine whether the external object 30 is within the first distance d1 from the antenna module 100.

In addition, the processor 110 according to an embodiment may control a transmit power for transmitting the second signal through the second antenna group 220, based on the distance between the external object 30 and the antenna module 100.

Referring to the above components, the first antenna group 210 for obtaining information about (or for measuring) the distance between the external object 30 and the antenna module 100 and the second antenna group 220 for wireless communication using a specified frequency band may be formed in the single antenna module 100 (or the single printed circuit board 20).

As such, the antenna module 100 according to an embodiment of the present disclosure may reduce the area (or size) for implementing the first antenna group 210 and the second antenna group 220.

Also, the processor 110 may control the RFIC 130 and the PMIC 150 to identify the distance between the external object 30 and the antenna module 100.

In addition, the processor 110 may transmit the second signal through the second antenna group 220 with a transmit power that is determined based on the distance identified through the first antenna group 210.

As such, the antenna module 100 according to the present disclosure may improve power efficiency for wireless communication by using the first antenna group 210 and the second antenna group 220 that are implemented in the single printed circuit board 20.

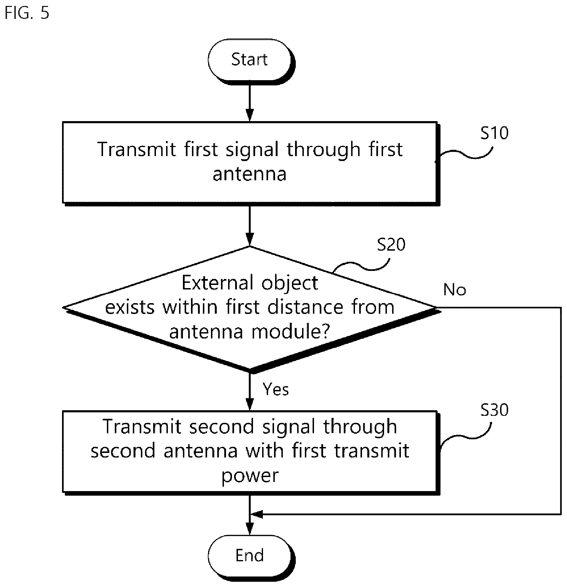

FIG. 5 is a flowchart illustrating an operation in which an antenna module controls a transmit power when an external object is within a first distance from the antenna module, according to an embodiment.

Referring to FIG. 5, the processor 110 (or the antenna module 100) according to an embodiment may control a transmit power for transmitting the second signal through the second antenna group 220, in response to a determination that the external object 30 is within a first distance from the antenna module 100.

A processor and an antenna module of FIG. 5 may be understood as corresponding to the processor 110 and the antenna module 100 of FIG. 1. Accordingly, components that are the same or substantially the same as the above components are marked by the same reference numerals/signs, and thus, additional description will be omitted to avoid redundancy.

When the external object 30 is within the first distance from the antenna module 100, the processor 110 may control the transmit power for transmitting the second signal through the second antenna group 220 so as to be set to a first maximum power or less corresponding to the first distance.

In operation S10, the processor 110 may transmit the first signal through the first antenna group 210. Here, the first signal may be transmitted through the first sensing antenna 211 included in the first antenna group 210.

For example, the processor 110 may transmit the first signal in the frequency band of about 60 GHz through the first sensing antenna 211. Herein, for example, the first signal may be referred to as a "radar signal for identifying the external object 30".

In operation S20, the processor 110 may determine whether the external object 30 is within the first distance d1 from the antenna module 100.

In detail, the processor 110 may receive the first signal reflected from the external object 30 to determine whether the external object 30 is within the first distance d1 from the antenna module 100.

According to an embodiment, the processor 110 may receive the first signal reflected by the external object 30 through the second sensing antenna 212.

For example, the processor 110 may determine whether the external object 30 is within the first distance d1 from the antenna module 100, based on the distance between the first sensing antenna 211 and the second sensing antenna 212 and an elapsed time from a point in time when the first signal is transmitted to a point in time when the first signal is received.

In operation S30, the processor 110 may transmit the first signal through the second antenna group 220 with a first transmit power.

In detail, when the external object 30 is within the first distance d1 from the antenna module 100, the processor 110 may transmit the second signal through the second antenna group 220 with the first transmit power that is less than or equal to the first maximum power set to correspond to the first distance.

Herein, for example, the maximum power according to a distance may be understood as an allowable power set to satisfy the standards associated with at least some of the specific absorption rate (SAR), the power density (PD), and the total exposure ratio (TER).

For example, the first maximum power may be set such that the total exposure ratio at which the external object 30 distant from the antenna module 100 as much as the first distance d1 is exposed to an electromagnetic wave emitted from the antenna module 100 is less than a reference value.

Also, for example, information about a maximum power according to the distance between the antenna module 100 and the external object 30 may be stored in the form of a lookup table. Accordingly, the antenna module 100 or an electronic device including the antenna module 100 may further include a memory storing the lookup table.

However, a scheme and a configuration associated with storing the information about the maximum power according to the distance between the antenna module 100 and the external object 30 are not limited to the above example.

For example, the second signal may be understood as an "mmWave signal" within a frequency band of about 28 GHz, but the present disclosure is not limited thereto.

Referring to the above components, the processor 110 according to an embodiment may transmit an RF signal through the second antenna group 220 with a transmit power less than or equal to a maximum power set depending on a separation distance between the external object 30 and the antenna module 100.

Accordingly, the antenna module 100 according to the present disclosure may improve power efficiency for wireless communication through use of an antenna group within a range in which the standard associated with the human body adjacent to the antenna module 100 is satisfied.

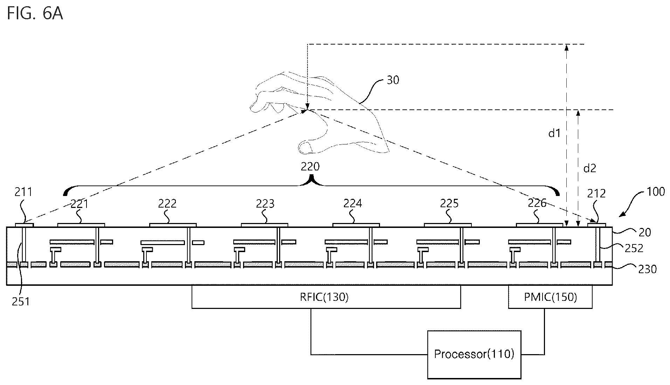

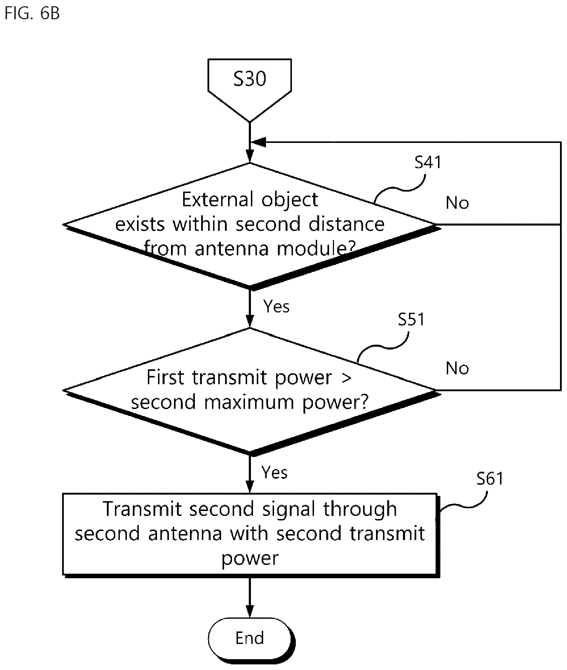

FIG. 6A illustrates a configuration in which an antenna module according to an embodiment senses an external object within a second distance from the antenna module. FIG. 6B is a flowchart illustrating an operation in which an antenna module of FIG. 6A controls a transmit power when an external object is within a second distance from the antenna module, according to an embodiment.

Referring to FIG. 6A, the processor 110 according to an embodiment may determine whether the external object 30 is within a second distance d2 less than the first distance d1 from the antenna module 100, through use of the first antenna group 210.

In addition, when the external object 30 is within the second distance d2 less than the first distance d1 from the antenna module 100, the processor 110 may transmit the second signal through the second antenna group 220 with a second transmit power.

Referring to FIG. 6B, in operation S41, the processor 110 may determine whether the external object 30 is within the second distance d2 from the antenna module 100.

In detail, while transmitting the second signal with the first transmit power, the processor 110 may determine, through the first antenna group 210, whether the external object 30 is within the second distance d2 less than the first distance d1 from the antenna module 100.

According to an embodiment, while transmitting the second signal with the first transmit power, the processor 110 may transmit the first signal through the first sensing antenna 211. Also, the processor 110 may receive the first signal reflected from the external object 30 through the second sensing antenna 212.

As such, the processor 110 may determine whether the external object 30 is within the second distance d2 less than the first distance d1 from the antenna module 100.

In another example, while transmitting the second signal with the first transmit power, the processor 110 may determine, through the first antenna group 210, whether the external object 30 has moved towards the antenna module 100 and is within the second distance d2 from the antenna module 100.

In operation S51, the processor 110 may determine whether the first transmit power is greater than a second maximum power set to correspond to the second distance d2.

When it is determined that the external object 30 is within the second distance d2 from the antenna module 100, the processor 110 may determine whether the first transmit power is greater than the second maximum power set to correspond to the second distance d2.

In this case, the second maximum power may be understood as a maximum power value set in advance to correspond to the second distance d2.

In operation S61, the processor 110 may transmit the second signal through the second antenna group 220 with the second transmit power.

In detail, when the external object 30 is within the second distance d2 from the antenna module 100 and the first transmit power is greater than the second maximum power, the processor 110 may transmit the second signal through the second antenna group 220 with the second transmit power that is less than the second maximum power.

Referring to the above components, the antenna module 100 may include the first antenna group 210 and the second antenna group 220 that are formed in the single printed circuit board 20.

The antenna module 100 may control a transmit power for wireless communication, which is performed through the second antenna group 220, based on location information of the external object 30 obtained through the first antenna group 210.

As such, the antenna module 100 according to the present disclosure may be implemented with a minimized area (or size).

Also, referring to the above components, when a distance between the antenna module 100 and the external object 30 is changed, the processor 110 may control the transmit power of the second antenna group 220 so as not to exceed a maximum power set to correspond to the changed distance.

Accordingly, the antenna module 100 according to the present disclosure may improve power efficiency for wireless communication within a range in which a standard associated with the human body adjacent to the antenna module 100 is satisfied.

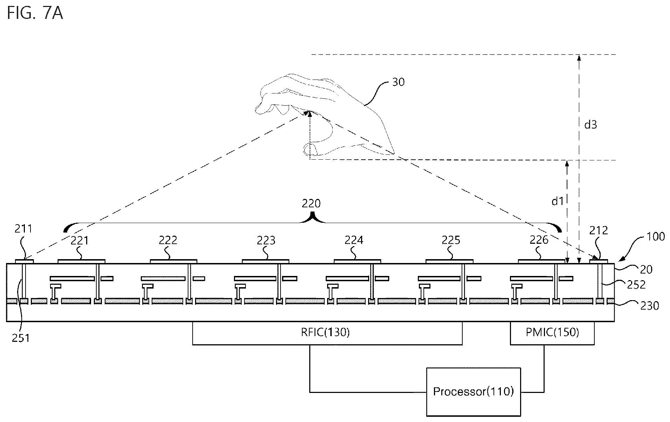

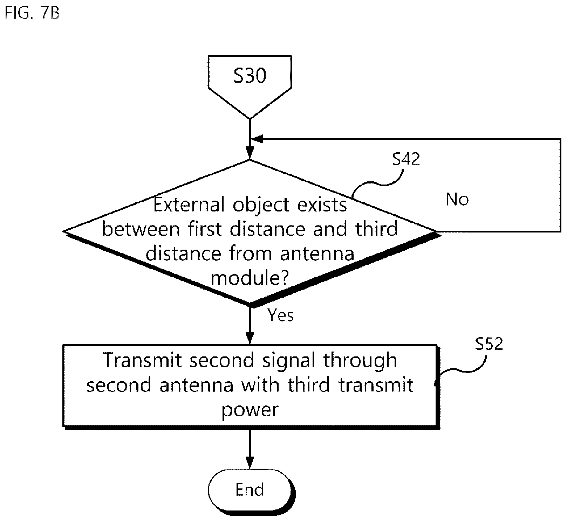

FIG. 7A illustrates a configuration in which an antenna module according to an embodiment senses an external object present between a first distance and a third distance from the antenna module. FIG. 7B is a flowchart illustrating an operation in which an antenna module of FIG. 7A controls a transmit power when an external object is present between a first distance and a third distance from the antenna module.

Referring to FIG. 7A, the processor 110 according to an embodiment may determine whether the external object 30 is present between the first distance d1 and a third distance d3 greater than the first distance d1 from the antenna module 100 by using the first antenna group 210.

In addition, when the external object 30 is present between the first distance d1 and the third distance d3 greater than the first distance d1 from the antenna module 100, the processor 110 may transmit the second signal through the second antenna group 220 with a third transmit power.

Referring to FIG. 7B, in operation S42, the processor 110 may determine whether the external object 30 is present between the first distance d1 and the third distance d3 from the antenna module 100.

To this end, while transmitting the second signal with the first transmit power, the processor 110 may determine, through the first antenna group 210, whether the external object 30 is present between the first distance d1 and the third distance d3 greater than the first distance d1 from the antenna module 100.

While transmitting the second signal with the first transmit power, the processor 110 may transmit the first signal through the first sensing antenna 211. Also, the processor 110 may receive the first signal reflected from the external object 30 through the second sensing antenna 212.

As such, the processor 110 may determine whether the external object 30 is present between the first distance d1 and the third distance d3 greater than the first distance d1 from the antenna module 100.

In another example, while transmitting the second signal with the first transmit power, the processor 110 may determine, through the first antenna group 210, whether the external object 30 has moved from the antenna module 100 and is present between the first distance d1 and the third distance d3 greater than the first distance d1 from the antenna module 100.

In operation S52, the processor 110 may transmit the second signal through the second antenna group 220 with the third transmit power.

In detail, when the external object 30 is within the first distance d1 and the third distance d3 from the antenna module 100, the processor 110 may transmit the second signal through the second antenna group 220 with the third transmit power that is less than or equal to a third maximum power and is greater than the first transmit power.

For example, when the external object 30 moves between the first distance d1 and the third distance d3 from the antenna module 100, the processor 110 may transmit the second signal through the second antenna group 220 with the third transmit power that is less than the third maximum power set to correspond to the third distance d3 and is greater than the first transmit power.

Herein, the third maximum power may be understood as an allowable power set to satisfy the standards associated with at least some of the specific absorption rate (SAR), the power density (PD), and the total exposure ratio (TER).

Referring to the above components, when a distance between the antenna module 100 and the external object 30 has changed, the processor 110 may control the transmit power of the second antenna group 220 so as not to exceed a maximum power set to correspond to the changed distance.

Accordingly, the antenna module 100 according to the present disclosure may improve power efficiency for wireless communication within a range in which the standard associated with the human body adjacent to the antenna module 100 is satisfied.

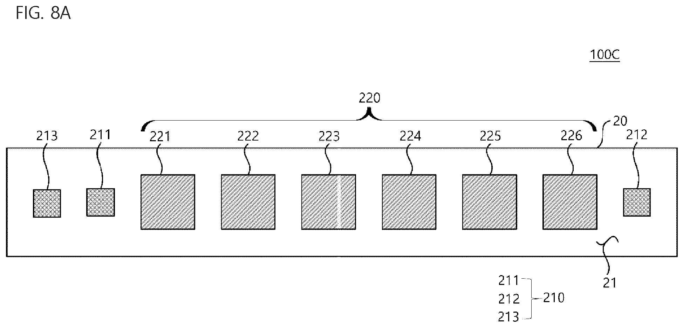

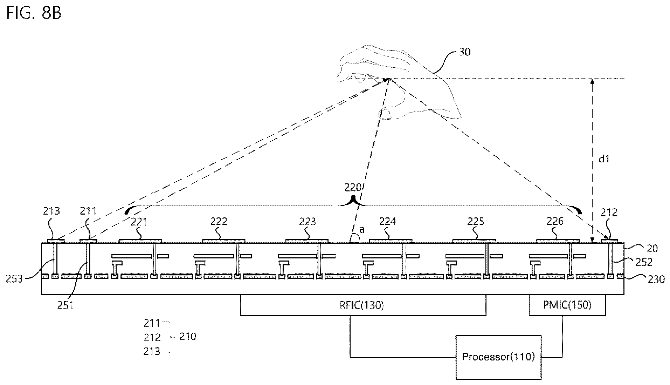

FIG. 8A illustrates an antenna module further including a third sensing antenna, according to another embodiment. FIG. 8B illustrates a configuration in which an antenna module of FIG. 8A obtains information about an angle formed by an external object and the antenna module by using a first antenna group.

Referring to FIGS. 8A and 8B together, an antenna module 100C may obtain information about an angle formed by the antenna module 100C and the external object 30 through use of the first antenna group 210.

The antenna module 100C illustrated in FIGS. 8A and 8B may be understood as an example of the antenna module 100 of FIG. 2A. Accordingly, components that are the same or substantially the same as the above components are marked by the same reference numerals/signs, and thus, additional description will be omitted to avoid redundancy.

According to an embodiment, the antenna module 100C (or the first antenna group 210) may further include a third sensing antenna 213 disposed adjacent to the first sensing antenna 211 or the second sensing antenna 212.

For example, the first antenna group 210 may further include the third sensing antenna 213 disposed adjacent to one side of the first sensing antenna 211, which is not adjacent to the second antenna group 220.

In another example, the first antenna group 210 may further include the third sensing antenna 213 disposed between the second sensing antenna 212 and the sixth antenna element 226.

However, the placement of the third sensing antenna 213 is not limited to the above examples.

Also, the third sensing antenna 213 according to an embodiment may be connected to a conductive pad disposed within an opening in the ground plane 230 through a third conductive via 253. The third sensing antenna 213 may be electrically connected to the first sensing antenna 211 and the second sensing antenna 212 through the third conductive via 253 and the ground plane 230. As such, the third sensing antenna 213 may form an antenna array together with the first sensing antenna 211.

The processor 110 may obtain information about an angle formed by the antenna module 100C and the external object 30 by using the first antenna group 210.

According to an embodiment, the processor 110 may transmit the first signal through the first sensing antenna 211 and the third sensing antenna 213. Also, the processor 110 may receive the first signal reflected by the external object 30 through the second sensing antenna 212.

In addition, the processor 110 may obtain information about an angle formed by the antenna module 100C and the external object 30 based on the first signal received through the second sensing antenna 212.

The processor 110 may obtain the angle formed by the external object 30 and the antenna module 100C, based on at least some of 1) a distance between the first sensing antenna 211 and the third sensing antenna 213; 2) a phase difference of the signal transmitted from the first sensing antenna 211 and the signal transmitted from the third sensing antenna 213; and 3) a difference between a time at which a signal transmitted from the first sensing antenna 211 is received through the second sensing antenna 212 and a time at which a signal transmitted from the third sensing antenna 213 is received through the second sensing antenna 212.

According to another embodiment, the processor 110 may transmit the first signal through the first sensing antenna 211. Also, the processor 110 may receive the first signal reflected by the external object 30 through the second sensing antenna 212 and the third sensing antenna 213.

In addition, the processor 110 may obtain information about an angle formed by the antenna module 100C and the external object 30 based on the first signals respectively received through the second sensing antenna 212 and the third sensing antenna 213.

For example, the processor 110 may obtain the angle formed by the external object 30 and the antenna module 100C, based on at least some of 1) a distance between the second sensing antenna 212 and the third sensing antenna 213, 2) a phase difference of the signal received through the second sensing antenna 212 and the signal received through the third sensing antenna 213, and 3) a difference between a time at which a signal is received through the second sensing antenna 212 and a time at which a signal is received through third sensing antenna 213.

In addition, the processor 110 may control a transmit power of the second antenna group 220, based on the following information obtained through the first antenna group 210: the distance between the antenna module 100C and the external object 30 and the angle formed by the antenna module 100C and the external object 30.

For example, the processor 110 may transmit the second signal through the second antenna group 220 with a transmit power less than a maximum power set to correspond to a point that is spaced from one point of the antenna module 100C as much as the first distance d1 and is at a first angle "a" with the antenna module 100C.

Referring to the above components, the processor 110 may control the transmit power of the second antenna group 220 so as not to exceed a maximum power set to correspond to a distance between the antenna module 100C and the external object 30 and an angle formed by the antenna module 100C and the external object 30.

Accordingly, the antenna module 100C according to the present disclosure may improve power efficiency for wireless communication within a range in which a standard associated with the human body adjacent to the antenna module 100C is satisfied.

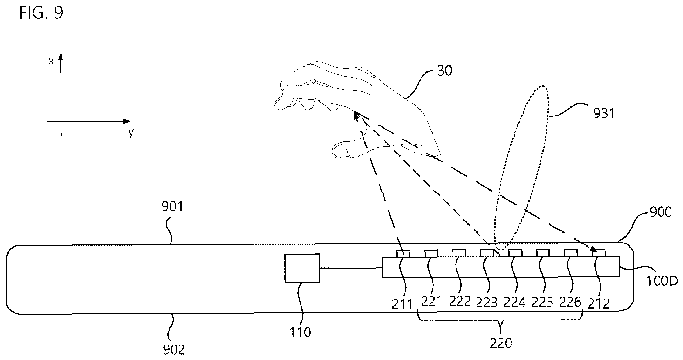

FIG. 9 illustrates a configuration in which an antenna module included in an electronic device according to an embodiment transmits a signal with a transmit power corresponding to a distance from an external object.

Referring to FIG. 9, an antenna module 100D included in an electronic device 900 according to an embodiment may control a transmit power of the second antenna group 220 depending on a distance between the antenna module 100D and the external object 30.

The antenna module 100D illustrated in FIGS. 9 may be understood as an example of the antenna module 100 of FIG. 2A. Accordingly, components that are the same or substantially the same as the above components are marked by the same reference numerals/signs, and thus, additional description will be omitted to avoid redundancy.

The electronic device 900 according to the present disclosure may be implemented with various types of devices. The electronic device 900 may be, for example, a portable communication device (e.g., a smartphone), a computer device, a portable multimedia device, a portable medical appliance, a camera, or a wearable device. However, the electronic device 900 according to an embodiment of the present disclosure is not limited to the above devices.

According to an embodiment, the antenna module 100D may be disposed inside the electronic device 900 so as to be adjacent to a first surface 901.

For example, when the electronic device 900 is a portable communication device, at least a portion of the first surface 901 may be implemented with a rear cover or a housing, and at least a portion of a second surface 902 may be implemented with a display.

Accordingly, the antenna module 100D may be disposed inside the electronic device 900 so as to be adjacent to the first surface 901 (e.g., a rear surface) on which a display is not disposed. However, the placement of the antenna module 100D in the electronic device 900 is not limited to the above example.

Also, the antenna module 100D may be disposed inside the electronic device 900 such that the first antenna group 210 and the second antenna group 220 face a first direction (e.g., a +x direction).

In detail, the antenna module 100D may be disposed inside the electronic device 900 such that the first antenna group 210 and the second antenna group 220 face the first direction (e.g., a +x direction) facing the first surface 901.

For example, the antenna module 100D may be disposed such that each of the first antenna group 210 and the second antenna group 220 emits a signal in a specified frequency band in the first direction (e.g., a +x direction) under control of the processor 110.

According to an embodiment, the processor 110 may transmit and receive the first signal through the first antenna group 210 facing the first direction (e.g., a +x direction) and may measure a distance between the external object 30 and the antenna module 100D.

Also, the processor 110 may control the transmit power of the second antenna group 220 based on the distance between the external object 30 and the antenna module 100D.

For example, the processor 110 may transmit the second signal through the second antenna group 220 with a transmit power that is less than or equal to a maximum power set to correspond to the distance between the external object 30 and the antenna module 100D.

In this case, the maximum power set to correspond to the distance between the external object 30 and the antenna module 100D may be understood as an allowable power set to satisfy at least some of the specific absorption rate (SAR), the power density (PD), and the total exposure ratio (TER) depending on a type and a characteristic of the electronic device 900.

For example, the second antenna group 220 may be understood as a 5G patch antenna including the plurality of antenna elements 221, 222, 223, 224, 225, and 226. Also, for example, the second signal transmitted through the second antenna group 220 may be understood as an mmWave whose frequency belongs to the frequency band of about 28 GHz.

Accordingly, the processor 110 may provide the second antenna group 220 with the transmit power less than or equal to the maximum power set depending on the distance between the external object 30 and the antenna module 100D and may form a directional beam 931 through the second antenna group 220.

Referring to the above components, the antenna module 100D included in the electronic device 900 may control a power for wireless communication within a range in which there is the standard associated with the human body adjacent to the electronic device 900 (or the antenna module 100D).

Accordingly, the antenna module 100D according to an embodiment of the present disclosure may improve power efficiency for wireless communication.

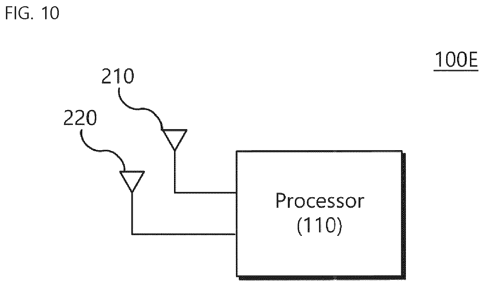

FIG. 10 is a block diagram illustrating an antenna module according to an embodiment of the present disclosure.

Referring to FIG. 10, an antenna module 100E may include the first antenna group 210, the second antenna group 220, and the processor 110.

The antenna module 100E of FIG. 10 may be referenced as an example of the antenna module 100 of FIG. 1. Accordingly, components that are the same or substantially the same as the above components are marked by the same reference numerals/signs, and thus, additional description will be omitted to avoid redundancy.

In detail, the antenna module 100E of FIG. 10 may be understood as a configuration in which the RFFE 120, the RFIC 130, and the PMIC 150 are removed from the antenna module 100 of FIG. 1.

At least some of the RFFE 120, the RFIC 130, and the PMIC 150 may be removed from the antenna module 100 of FIG. 1 by one skilled in the art, as illustrated by the antenna module 100E of FIG. 10.

Referring to FIGS. 2A and 10 together, the antenna module 100E may include the first antenna group 210 including the first sensing antenna 211 and the second sensing antenna 212.

In detail, the antenna module 100E may include the first sensing antenna 211 and the second sensing antenna 212 disposed on the first surface 21 of the printed circuit board 20.

According to an embodiment, the processor 110 may transmit and receive the first signal in the first frequency band (e.g., 60 GHz) by using the first sensing antenna 211 and the second sensing antenna 212.

For example, the processor 110 may transmit the first signal by using the first sensing antenna 211. Also, the processor 110 may receive the first signal by using the second sensing antenna 212.

According to an embodiment, the antenna module 100E may include the processor 110 electrically connected to the printed circuit board 20, the first antenna group 210, and the second antenna group 220.

The processor 110 may obtain information about a distance between the external object 30 and the antenna module 100E, based on the first signal transmitted and received through the first antenna group 210.

In detail, the processor 110 may receive, through the second sensing antenna 212, the first signal that is transmitted through the first sensing antenna 211 and is then reflected by the external object 30. The processor 110 may obtain location information of the external object 30, based on the first signal received through the second sensing antenna 212.

For example, the processor 110 may measure the distance between the antenna module 100E and the external object 30, based on the radar signal received through the second sensing antenna 212.

For example, based on the distance information, the processor 110 may determine whether the external object 30 is within a first distance from the antenna module 100E.

The antenna module 100E may include the second antenna group 220 disposed on the first surface 21 of the printed circuit board 20.

In detail, the antenna module 100E may include the second antenna group 220 including the plurality of antenna elements 221- 226 that are disposed on the first surface 21 of the printed circuit board 20 between the first sensing antenna 211 and the second sensing antenna 212.

According to an embodiment, the processor 110 may control a transmit power for transmitting the second signal through the second antenna group 220, based on the distance information.

In detail, based on the distance information, the processor 110 may control the transmit power of the second antenna group 220 to be less than or equal to a maximum power set depending on the distance between the antenna module 100E and the external object 30.

For example, when the external object 30 is within the first distance d1 from the antenna module 100E, the processor 110 may transmit the second signal through the second antenna group 220 with the first transmit power that is less than or equal to the first maximum power set to correspond to the first distance d1.

Referring to the above components, the antenna module 100E may include the first antenna group 210 that is used to obtain the location information of the external object 30 and the second antenna group 220 that is used to transmit a wireless communication signal with a transmit power according to the location information. Herein, the first antenna group 210 and the second antenna group 220 may be formed in a single printed circuit board.

As such, the antenna module 100E according to the present disclosure may be implemented with a minimized area (or size).

Also, the processor 110 may transmit an RF signal through the second antenna group 220 with a transmit power that is determined based on the distance between the external object 30 and the antenna module 100E identified through the first antenna group 210.

Accordingly, the antenna module 100E according to the present disclosure may improve power efficiency for wireless communication within a range in which the standard associated with the human body adjacent to the antenna module 100E is satisfied.

As described above, the antenna module 100E according to an embodiment of the present disclosure may include the first antenna group 210 that is used to obtain the location information of the external object 30 and the second antenna group 220 that is used to transmit a wireless communication signal with a transmit power according to the location information. Herein, the first antenna group 210 and the second antenna group 220 may be formed in a single printed circuit board.

As such, the antenna module 100 according to the present disclosure may be implemented with a minimized area (or size).

Also, the antenna module 100 according to an embodiment of the present disclosure may transmit an RF signal through the second antenna group 220 with a transmit power that is determined based on the distance between the external object 30 and the antenna module 100E identified through the first antenna group 210.

Also, when a distance between the antenna module 100 and the external object 30 is changed, the antenna module 100 according to an embodiment of the present disclosure may control the transmit power of the second antenna group 220 so as not to exceed a maximum power set to correspond to the changed distance.

Accordingly, the antenna module 100 according to the present disclosure may improve power efficiency for wireless communication within a range in which a standard associated with the human body adjacent to the antenna module 100 is satisfied.

Also, the antenna module 100 according to an embodiment may increase a length of an electrical connection path of undesirable surface waves between the first sensing antenna 211 and the second sensing antenna 212 reflected by a ground plane.

As such, the antenna module 100 according to the present disclosure may improve the isolation between the first sensing antenna 211 and the second sensing antenna 212.

In addition, the antenna module 100 according to the present disclosure may improve the performance of the first antenna group 210 including the first sensing antenna 211 and the second sensing antenna 212.

An antenna module according to an embodiment of the present disclosure includes an antenna group for obtaining location information of an external object and an antenna group for transmitting an RF signal with a transmit power corresponding to the location information.

Accordingly, the antenna module may occupy a smaller area as compared to conventional designs.

While the present disclosure has been described with reference to embodiments thereof, it will be apparent to those of ordinary skill in the art that various changes and modifications may be made thereto without departing from the scope of the present disclosure as set forth in the following claims.

## Claims

1. An antenna module comprising:
a printed circuit board (20);
a first antenna group (210), including a first sensing antenna (211) and a second sensing antenna (212) disposed on a first surface (21) of the printed circuit board, and configured to transmit and receive a first signal;
a second antenna group (220) including a plurality of antenna elements (221-226) disposed on the first surface between the first sensing antenna and the second sensing antenna; and
a processor (110) coupled to the printed circuit board, the first antenna group, and the second antenna group,
wherein the processor is configured to:
obtain information about a distance between an external object (30) and the antenna module, based on the first signal transmitted and received through the first antenna group; and
when the external object is within a first distance (d1) from the antenna module, transmit a second signal through the second antenna group with a first transmit power less than or equal to a first maximum power set to correspond to the first distance,
wherein the first signal is transmitted and received within a first frequency band, and the second signal is transmitted in a second frequency band different from the first frequency band.

2. The antenna module of claim 1, wherein the processor (110) is configured to:
while the second signal is transmitted with the first transmit power, determine whether the external object (30) is within a second distance (d2) less than the first distance (d1) from the antenna module, through the first antenna group (210); and
when the external object is within the second distance from the antenna module and the first transmit power is greater than a second maximum power set to correspond to the second distance, transmit the second signal through the second antenna group (220) with a second transmit power less than or equal to the second maximum power.

3. The antenna module of claim 1 or claim 2, wherein the processor (110) is configured to:
while the second signal is transmitted with the first transmit power, determine whether the external object (30) is between the first distance (d1) and a third distance (d3) greater than the first distance (d1) from the antenna module, through the first antenna group (210), if so, cause the second signal to be transmitted through the second antenna group (220) with a third transmit power greater than the first transmit power and less than a third maximum power set to correspond to the third distance.

4. The antenna module of any preceding claim, wherein, the plurality of antenna elements (221-226) of the second antenna group (220) comprises at least three antenna elements disposed between the first sensing antenna (211) and the second sensing antenna (212) at given intervals (W1) therebetween.

5. The antenna module of any preceding claim, wherein:
the first signal is transmitted to the external object (30) through the first sensing antenna (211);
the processor (110) receives the first signal, which is transmitted from the first sensing antenna and is reflected by the external object (30), through the second sensing antenna (212); and
the processor obtains the information about the distance between the antenna module and the external object, based on the first signal received through the second sensing antenna.

6. The antenna module of claim 1, wherein:
the first antenna group (210) further includes a third sensing (213) antenna disposed adjacent to the first sensing antenna (211) or the second sensing antenna (212);
the first signal is transmitted through at least one of the first to third sensing antennas; and
the processor (110) is configured to receive the first signal reflected by the external object (30) through a sensing antenna, which does not transmit the first signal, from among the first to third sensing antennas, and obtain information about an angle (a) formed by the antenna module and the external object, based on the first signal thus received.

7. The antenna module of any preceding claim, wherein the printed circuit board (20) includes:
a ground plane (230) spaced from the first surface (21) by a first height (H1), and configured to reflect signal energy to/from the plurality of antenna elements, and
wherein the first sensing antenna (211) is connected to a first conductive pad (263) within an opening in the ground plane through a first conductive via (251), and the second sensing antenna (212) is connected to a second conductive pad (263) within an opening in the ground plane through a second conductive via (252).

8. The antenna module of claim 7, wherein the printed circuit board (20) includes:
a first local ground plane (311a) spaced from the first surface (21) by a second height (H2) less than the first height (H1) and surrounding the first conductive via (251), the first local ground plane configured to reflect signal energy to/from the first sensing antenna (211); and
a second local ground plane (311b) spaced from the first surface by the second height and surrounding the second conductive via (252), the second local ground plane configured to reflect signal energy to/from the second sensing antenna (212).

9. The antenna module of any preceding claim, further comprising:
a radio frequency integrated circuit (130), hereafter RFIC, disposed on a second surface (22) of the printed circuit board (20), which is parallel to the first surface (21), and
wherein the RFIC is electrically connected to the first antenna group (210) and the second antenna group (220).

10. The antenna module of any preceding claim, further comprising:
a memory configured to store a lookup table including information about a maximum power according to the distance between the antenna module and the external object (30), and
wherein the processor (110) identifies a maximum power set depending on the distance between the antenna module and the external object, based on the lookup table stored in the memory.

11. A wireless communication method using an antenna module, the method comprising:
transmitting a first signal towards an external object (30) through a first sensing antenna (211) or a second sensing antenna (212) included in a first antenna group (210);
determining whether the external object is within a first distance (d1) from the antenna module, based on the first signal reflected by the external object and received through the first antenna group; and
when the external object is determined to be within the first distance from the antenna module, transmitting a second signal through at least one of a plurality of antenna elements (221-226) included in a second antenna group (220) with a first transmit power less than or equal to a first maximum power set to correspond to the first distance,
wherein the plurality of antenna elements are disposed between the first sensing antenna and the second sensing antenna, and
wherein the first signal is transmitted and received within a first frequency band, and the second signal is transmitted in a second frequency band different from the first frequency band.

12. The method of claim 11, further comprising:
while the second signal is transmitted with the first transmit power, determining whether the external object (30) is within a second distance (d2) less than the first distance (d1) from the antenna module, through a signal transmitted and received by the first antenna group (210); and
when the external object is within the second distance from the antenna module and the first transmit power is greater than a second maximum power set to correspond to the second distance, transmitting the second signal through the second antenna group (220) with a second transmit power less than or equal to the second maximum power.

13. The method of claim 11, further comprising:
while the second signal is transmitted with the first transmit power, determining whether the external object (30) is between the first distance (d1) and a third distance (d3) greater than the first distance from the antenna module, through a signal transmitted and received by the first antenna group (210); and
when the external object is between the first distance and the third distance from the antenna module, transmitting the second signal through the second antenna group (220) with a third transmit power greater than the first transmit power and less than a third maximum power set to correspond to the third distance.

14. The method of any one of claims 11 - 13, further comprising:
transmitting the first signal to the external object (30) through the first sensing antenna (211);
receiving the first signal, which is transmitted from the first sensing antenna and is reflected by the external object, through the second sensing antenna (212); and
determining whether the external object is within the first distance (d1) from the antenna module, based on the first signal received through the second sensing antenna.

15. The method of any one of claims 11 - 13, wherein the first antenna group (210) further includes:
a third sensing antenna (213) disposed adjacent to the first sensing antenna (211) or the second sensing antenna (212), and
wherein the method further comprises:
transmitting the first signal through at least one of the first to third sensing antennas;
receiving the first signal reflected by the external object (30) through a sensing antenna, which does not transmit the first signal, from among the first to third sensing antennas; and
obtaining information about an angle (a) formed by the antenna module and the external object, based on the first signal thus received.

## Patentansprüche

1. Antennenmodul, umfassend:
eine Leiterplatte (20);
eine erste Antennengruppe (210), welche eine erste Erfassungsantenne (211) und eine zweite Erfassungsantenne (212) beinhaltet, welche auf einer ersten Oberfläche (21) der Leiterplatte angeordnet und dazu konfiguriert sind, ein erstes Signal zu senden und zu empfangen;
eine zweite Antennengruppe (220), welche eine Vielzahl von Antennenelementen (221-226) beinhaltet, welche auf der ersten Oberfläche zwischen der ersten Erfassungsantenne und der zweiten Erfassungsantenne angeordnet sind; und
einen Prozessor (110), welcher mit der Leiterplatte, der ersten Antennengruppe und der zweiten Antennengruppe gekoppelt ist,
wobei der Prozessor dazu konfiguriert ist:
Informationen über einen Abstand zwischen einem externen Objekt (30) und dem Antennenmodul basierend auf dem ersten über die erste Antennengruppe gesendeten und empfangenen Signal zu gewinnen; und
wenn sich das externe Objekt innerhalb eines ersten Abstands (d1) von dem Antennenmodul befindet, ein zweites Signal über die zweite Antennengruppe mit einer ersten Sendeleistung zu senden, welche kleiner oder gleich einer ersten maximalen Leistung ist, welche so eingestellt ist, dass sie dem ersten Abstand entspricht,
wobei das erste Signal in einem ersten Frequenzband gesendet und empfangen wird, und das zweite Signal in einem zweiten, von dem ersten Frequenzband verschiedenen Frequenzband gesendet wird.

2. Antennenmodul nach Anspruch 1, wobei der Prozessor (110) dazu konfiguriert ist:
während das zweite Signal mit der ersten Sendeleistung gesendet wird, durch die erste Antennengruppe (210) zu bestimmen, ob sich das externe Objekt (30) innerhalb eines zweiten Abstands (d2), welcher kleiner als der erste Abstand (d1) ist, von dem Antennenmodul befindet; und
wenn sich das externe Objekt innerhalb des zweiten Abstands von dem Antennenmodul befindet und die erste Sendeleistung größer ist als eine zweite maximale Leistung, welche so eingestellt ist, dass sie dem zweiten Abstand entspricht, das zweite Signal mit einer zweiten Sendeleistung, welche kleiner oder gleich der zweiten maximalen Leistung ist, über die zweite Antennengruppe (220) zu senden.

3. Antennenmodul nach Anspruch 1 oder Anspruch 2, wobei der Prozessor (110) dazu konfiguriert ist:
während das zweite Signal mit der ersten Sendeleistung gesendet wird, durch die erste Antennengruppe (210) zu bestimmen, ob sich das externe Objekt (30) zwischen dem ersten Abstand (d1) und einem dritten Abstand (d3), welcher kleiner als der erste Abstand (d1) ist, von dem Antennenmodul befindet; wenn ja, zu veranlassen, dass das zweite Signal mit einer dritten Sendeleistung, welche größer als die erste Sendeleistung und kleiner als eine dritte maximale Leistung ist, welche so eingestellt ist, dass sie dem dritten Abstand entspricht, über die zweite Antennengruppe (220) gesendet wird.

4. Antennenmodul nach einem vorstehenden Anspruch, wobei die Vielzahl von Antennenelementen (221-226) der zweiten Antennengruppe (220) zumindest drei Antennenelemente umfasst, welche zwischen der ersten Erfassungsantenne (211) und der zweiten Erfassungsantenne (212) in vorgegebenen Intervallen (W1) dazwischen angeordnet sind.

5. Antennenmodul nach einem vorstehenden Anspruch, wobei:
das erste Signal über die erste Erfassungsantenne (211) an das externe Objekt (30) gesendet wird;
der Prozessor (110) das erste Signal, welches von der ersten Erfassungsantenne gesendet wird und von dem externen Objekt (30) reflektiert wird, über die zweite Erfassungsantenne (212) empfängt; und
der Prozessor die Informationen über den Abstand zwischen dem Antennenmodul und dem externen Objekt basierend auf dem ersten Signal gewinnt, welches über die zweite Erfassungsantenne empfangen wird.

6. Antennenmodul nach Anspruch 1, wobei:
die erste Antennengruppe (210) weiter eine dritte Erfassungsantenne (213) beinhaltet, welche neben der ersten Erfassungsantenne (211) oder der zweiten Erfassungsantenne (212) angeordnet ist;
das erste Signal über zumindest eine der ersten bis dritten Erfassungsantenne gesendet wird; und
der Prozessor (110) dazu konfiguriert ist, das erste von dem externen Objekt (30) reflektierte Signal, aus der ersten bis dritten Erfassungsantenne, über eine Erfassungsantenne, welche das erste Signal nicht sendet, zu empfangen, und basierend auf dem so empfangenen ersten Signal Informationen über einen Winkel (a) zu gewinnen, welcher von dem Antennenmodul und dem externen Objekt gebildet wird.

7. Antennenmodul nach einem vorstehenden Anspruch, wobei die Leiterplatte (20) beinhaltet:
eine Massefläche (230), welche von der ersten Oberfläche (21) durch eine erste Höhe (H1) beabstandet ist, und dazu konfiguriert ist, Signalleistung an die bzw. von der Vielzahl von Antennenelementen zu reflektieren, und
wobei die erste Erfassungsantenne (211) mit einem ersten leitfähigen Pad (263) innerhalb einer Öffnung in der Massefläche über eine erste leitfähige Durchverbindung (251) verbunden ist, und die zweite Erfassungsantenne (212) mit einem zweiten leitfähigen Pad (263) innerhalb einer Öffnung in der Massefläche über eine zweite leitfähige Durchverbindung (252) verbunden ist.

8. Antennenmodul nach Anspruch 7, wobei die Leiterplatte (20) beinhaltet:
eine erste lokale Massefläche (311a), welche von der ersten Oberfläche (21) durch eine zweite Höhe (H2) beabstandet ist, welche kleiner als die erste Höhe (H1) ist und die erste leitfähige Durchverbindung (251) umgibt, wobei die erste lokale Massefläche dazu konfiguriert ist, Signalleistung an die erste bzw. von der ersten Erfassungsantenne (211) zu reflektieren; und
eine zweite lokale Massefläche (311b), welche von der ersten Oberfläche durch eine zweite Höhe beabstandet ist und die zweite leitfähige Durchverbindung (252) umgibt, wobei die zweite lokale Massefläche dazu konfiguriert ist, Signalleistung an die zweite bzw. von der zweiten Erfassungsantenne (212) zu reflektieren.

9. Antennenmodul nach einem vorstehenden Anspruch, weiter umfassend:
einen integrierten Hochfrequenzschaltkreis (130), im Folgenden RFIC, welcher auf einer zweiten Oberfläche (22) der Leiterplatte (20) angeordnet ist, welche parallel zu der ersten Oberfläche (21) verläuft, und
wobei der RFIC mit der ersten Antennengruppe (210) und der zweiten Antennengruppe (220) elektrisch verbunden ist.

10. Antennenmodul nach einem vorstehenden Anspruch, weiter umfassend:
einen Speicher, welcher dazu konfiguriert ist, eine Nachschlagetabelle zu speichern, welche Informationen über eine maximale Leistung gemäß dem Abstand zwischen dem Antennenmodul und dem externen Objekt (30) beinhaltet, und
wobei der Prozessor (110) basierend auf der im Speicher gespeicherten Nachschlagetabelle eine maximale Leistung identifiziert, in Abhängigkeit von dem Abstand zwischen dem Antennenmodul und dem externen Objekt.

11. Drahtloskommunikationsverfahren, unter Verwendung eines Antennenmoduls, wobei das Verfahren umfasst:
Senden eines ersten Signals zu einem externen Objekt (30) durch eine erste Erfassungsantenne (211) oder eine zweite Erfassungsantenne (212), welche in einer ersten Antennengruppe (210) beinhaltet sind;
basierend auf dem ersten Signal, welches von dem externen Objekt reflektiert und von der ersten Antennengruppe empfangen wird, Bestimmen, ob sich das externe Objekt innerhalb eines ersten Abstands (d1) von dem Antennenmodul befindet; und
wenn bestimmt wird, dass sich das externe Objekt innerhalb des ersten Abstands von dem Antennenmodul befindet, Senden eines zweiten Signals über zumindest eine aus einer Vielzahl von Antennenelementen (221-226), welche in einer zweiten Antennengruppe (220) beinhaltet sind, mit einer ersten Sendeleistung, welche kleiner oder gleich einer ersten maximalen Leistung ist, welche so eingestellt ist, dass sie dem ersten Abstand entspricht,
wobei die Vielzahl von Antennenelementen zwischen der ersten Erfassungsantenne und der zweiten Erfassungsantenne angeordnet sind, und
wobei das erste Signal in einem ersten Frequenzband gesendet und empfangen wird, und das zweite Signal in einem zweiten, von dem ersten Frequenzband verschiedenen Frequenzband gesendet wird.

12. Verfahren nach Anspruch 11, weiter umfassend:
während das zweite Signal mit der ersten Sendeleistung gesendet wird, Bestimmen, ob sich das externe Objekt (30) innerhalb eines zweiten Abstands (d2), welcher kleiner als der erste Abstand (d1) ist, von dem Antennenmodul befindet, durch ein von der ersten Antennengruppe (210) gesendetes und empfangenes Signal; und
wenn sich das externe Objekt innerhalb des zweiten Abstands von dem Antennenmodul befindet und die erste Sendeleistung größer ist als eine zweite maximale Leistung, welche so eingestellt ist, dass sie dem zweiten Abstand entspricht, Senden das zweite Signal mit einer zweiten Sendeleistung, welche kleiner oder gleich der zweiten maximalen Leistung ist, über die zweite Antennengruppe (220).

13. Verfahren nach Anspruch 11, weiter umfassend:
während das zweite Signal mit der ersten Sendeleistung gesendet wird, Bestimmen, ob sich das externe Objekt (30) zwischen dem ersten Abstand (d1) und einem dritten Abstand (d3), welcher kleiner als der erste Abstand ist, von dem Antennenmodul befindet, durch ein von der ersten Antennengruppe (210) gesendetes und empfangenes Signal; und
wenn sich das externe Objekt zwischen dem ersten Abstand und dem dritten Abstand von dem Antennenmodul befindet, Senden des zweiten Signals über die zweite Antennengruppe (220) mit einer dritten Sendeleistung, welcher größer als die erste Sendeleistung und kleiner als eine dritte maximale Leistung ist, welche so eingestellt ist, dass sie dem dritten Abstand entspricht.

14. Verfahren nach einem der Ansprüche 11-13, weiter umfassend:
Senden des ersten Signals über die erste Erfassungsantenne (211) an das externe Objekt (30);
Empfangen des ersten Signals, welches von der ersten Erfassungsantenne gesendet wird und von dem externen Objekt reflektiert wird, über die zweite Erfassungsantenne (212); und
basierend auf dem ersten Signal, welches von der zweiten Erfassungsantenne empfangen wird, Bestimmen, ob sich das externe Objekt innerhalb des ersten Abstands (d1) von dem Antennenmodul befindet.

15. Verfahren nach einem der Ansprüche 11-13, wobei die erste Antennengruppe (210) weiter beinhaltet:
eine dritte Erfassungsantenne (213), welche neben der ersten Erfassungsantenne (211) oder der zweiten Erfassungsantenne (212) angeordnet ist; und
wobei das Verfahren weiter umfasst:
Senden des ersten Signals über zumindest eine der ersten bis dritten Erfassungsantenne;
Empfangen des ersten von dem externen Objekt (30) reflektierten Signals über eine Erfassungsantenne, welche das erste Signal nicht sendet, aus der ersten bis dritten Erfassungsantenne; und
Gewinnen von Informationen über einen Winkel (a), welcher von dem Antennenmodul und dem externen Objekt gebildet wird, basierend auf dem so empfangenen ersten Signal.

## Revendications

1. Module d'antenne comprenant :
une carte de circuit imprimé (20) ;
un premier groupe d'antennes (210), incluant une première antenne de détection (211) et une deuxième antenne de détection (212) disposées sur une première surface (21) de la carte de circuit imprimé, et configurées pour transmettre et recevoir un premier signal ;
un second groupe d'antennes (220) incluant une pluralité d'éléments d'antenne (221-226) disposés sur la première surface entre la première antenne de détection et la deuxième antenne de détection ; et
un processeur (110) couplé à la carte de circuit imprimé, au premier groupe d'antennes et au second groupe d'antennes,
dans lequel le processeur est configuré pour :
obtenir des informations sur la distance entre un objet externe (30) et le module d'antenne, sur la base du premier signal transmis et reçu par le premier groupe d'antennes ; et
lorsque l'objet externe se trouve à une première distance (d1) du module d'antenne, transmettre un second signal par le second groupe d'antennes avec une première puissance d'émission inférieure ou égale à une première puissance maximale réglée pour correspondre à la première distance,
dans lequel le premier signal est transmis et reçu dans une première bande de fréquences, et le second signal est transmis dans une seconde bande de fréquences différente de la première bande de fréquences.

2. Module d'antenne selon la revendication 1, dans lequel le processeur (110) est configuré pour :
pendant que le second signal est transmis avec la première puissance d'émission, déterminer si l'objet externe (30) se trouve à une deuxième distance (d2) inférieure à la première distance (d1) du module d'antenne, par le premier groupe d'antennes (210) ; et
lorsque l'objet externe se trouve à une deuxième distance du module d'antenne et que la première puissance d'émission est supérieure à une deuxième puissance maximale réglée pour correspondre à la deuxième distance, transmettre le second signal par le second groupe d'antennes (220) avec une deuxième puissance d'émission inférieure ou égale à la deuxième puissance maximale.

3. Module d'antenne selon la revendication 1 ou la revendication 2, dans lequel le processeur (110) est configuré pour :
pendant que le second signal est transmis avec la première puissance d'émission, déterminer si l'objet externe (30) se trouve entre la première distance (d1) et une troisième distance (d3) supérieure à la première distance (d1) du module d'antenne, par le premier groupe d'antennes (210), si tel est le cas, amener le second signal à être transmis par le second groupe d'antennes (220) avec une troisième puissance d'émission supérieure à la première puissance d'émission et inférieure à une troisième puissance maximale réglée pour correspondre à la troisième distance.

4. Module d'antenne selon une quelconque revendication précédente, dans lequel la pluralité d'éléments d'antenne (221-226) du second groupe d'antennes (220) comprend au moins trois éléments d'antenne disposés entre la première antenne de détection (211) et la deuxième antenne de détection (212) à des intervalles (W1) donnés entre elles.

5. Module d'antenne selon une quelconque revendication précédente, dans lequel :
le premier signal est transmis à l'objet externe (30) par la première antenne de détection (211) ;
le processeur (110) reçoit le premier signal, qui est transmis depuis la première antenne de détection et réfléchi par l'objet externe (30), par la deuxième antenne de détection (212) ; et
le processeur obtient les informations sur la distance entre le module d'antenne et l'objet externe, sur la base du premier signal reçu par la deuxième antenne de détection.

6. Module d'antenne selon la revendication 1, dans lequel :
le premier groupe d'antennes (210) inclut en outre une troisième antenne de détection (213) disposée de manière adjacente à la première antenne de détection (211) ou la deuxième antenne de détection (212) ;
le premier signal est transmis par au moins l'une des trois antennes de détection ; et
le processeur (110) est configuré pour recevoir le premier signal réfléchi par l'objet externe (30) par une antenne de détection, qui ne transmet pas le premier signal, par l'une parmi les première à troisième antennes de détection, et obtenir des informations sur un angle (a) formé par le module d'antenne et l'objet externe, sur la base du premier signal ainsi reçu.

7. Module d'antenne selon une quelconque revendication précédente, dans lequel la carte de circuit imprimé (20) inclut :
un plan au sol (230) espacé de la première surface (21) d'une première hauteur (H1), et configuré pour réfléchir l'énergie du signal vers/depuis la pluralité d'éléments d'antenne, et
dans lequel la première antenne de détection (211) est reliée à une première pastille conductrice (263) dans une ouverture du plan au sol par l'intermédiaire d'un premier via conducteur (251), et la deuxième antenne de détection (212) est reliée à une seconde pastille conductrice (263) dans une ouverture du plan au sol par l'intermédiaire d'un second via conducteur (252).

8. Module d'antenne selon la revendication 7, dans lequel la carte de circuit imprimé (20) inclut :
un premier plan au sol local (311a) espacé de la première surface (21) d'une seconde hauteur (H2) inférieure à la première hauteur (H1) et entourant le premier via conducteur (251), le premier plan au sol local étant configuré pour réfléchir l'énergie du signal vers/depuis la première antenne de détection (211) ; et
un second plan au sol local (311b) espacé de la première surface d'une seconde hauteur et entourant le second via conducteur (252), le second plan au sol local étant configuré pour réfléchir l'énergie du signal vers/depuis la deuxième antenne de détection (212).

9. Module d'antenne selon une quelconque revendication précédente, comprenant en outre :
un circuit intégré de radiofréquence (130), ci-après RFIC, disposé sur une seconde surface (22) de la carte de circuit imprimé (20), qui est parallèle à la première surface (21), et
dans lequel le RFIC est relié électriquement au premier groupe d'antennes (210) et au second groupe d'antennes (220).

10. Module d'antenne selon une quelconque revendication précédente, comprenant en outre :
une mémoire configurée pour stocker une table de correspondance contenant des informations sur la puissance maximale en fonction de la distance entre le module d'antenne et l'objet externe (30), et
dans lequel le processeur (110) identifie un réglage de puissance maximale en fonction de la distance entre le module d'antenne et l'objet externe, sur la base de la table de correspondance stockée dans la mémoire.

11. Procédé de communication sans fil utilisant un module d'antenne, le procédé comprenant :
la transmission d'un premier signal vers un objet externe (30) par une première antenne de détection (211) ou une deuxième antenne de détection (212) incluse dans un premier groupe d'antennes (210) ;
la détermination permettant de savoir si l'objet externe se trouve à une première distance (d1) du module d'antenne, sur la base du premier signal réfléchi par l'objet externe et reçu par le premier groupe d'antennes ; et
lorsque l'objet externe est déterminé comme se trouvant à la première distance du module d'antenne, la transmission d'un second signal par au moins l'un parmi une pluralité d'éléments d'antenne (221-226) incluse dans un second groupe d'antenne (220) avec une première puissance d'émission inférieure ou égale à une première puissance maximale réglée pour correspondre à la première distance,
dans lequel la pluralité d'éléments d'antenne sont disposés entre la première antenne de détection et la deuxième antenne de détection, et
dans lequel le premier signal est transmis et reçu dans une première bande de fréquences, et le second signal est transmis dans une seconde bande de fréquences différente de la première bande de fréquences.

12. Procédé selon la revendication 11, comprenant en outre :
pendant que le second signal est transmis avec la première puissance d'émission, la détermination permettant de savoir si l'objet externe (30) se trouve à une deuxième distance (d2) inférieure à la première distance (d1) du module d'antenne, par l'intermédiaire d'un signal transmis et reçu par le premier groupe d'antennes (210) ; et
lorsque l'objet externe se trouve à la seconde distance du module d'antenne et que la première puissance d'émission est supérieure à une deuxième puissance maximale réglée pour correspondre à la seconde distance, la transmission du second signal par le second groupe d'antennes (220) avec une deuxième puissance d'émission inférieure ou égale à la deuxième puissance maximale.

13. Procédé selon la revendication 11, comprenant en outre :
pendant que le second signal est transmis avec la première puissance d'émission, la détermination permettant de savoir si l'objet externe (30) se trouve entre la première distance (d1) et une troisième distance (d3) supérieure à la première distance du module d'antenne, par l'intermédiaire d'un signal transmis et reçu par le premier groupe d'antennes (210) ; et
lorsque l'objet externe se trouve entre la première distance et la troisième distance du module d'antenne, la transmission du second signal par le second groupe d'antennes (220) avec une troisième puissance d'émission supérieure à la première puissance d'émission et inférieure à une troisième puissance maximale réglée pour correspondre à la troisième distance.

14. Procédé selon l'une quelconque des revendications 11-13 comprenant en outre :
la transmission du premier signal à l'objet externe (30) par la première antenne de détection (211) ;
la réception du premier signal, qui est transmis par la première antenne de détection et réfléchi par l'objet externe, par la deuxième antenne de détection (212) ; et
la détermination permettant de savoir si l'objet externe se trouve à la première distance (d1) du module d'antenne, sur la base du premier signal reçu par la deuxième antenne de détection.

15. Procédé selon l'une quelconque des revendications 11-13, dans lequel le premier groupe d'antennes (210) inclut en outre :
une troisième antenne de détection (213) disposée de manière adjacente à la première antenne de détection (211) ou la deuxième antenne de détection (212), et
dans lequel le procédé comprend en outre :
la transmission du premier signal par au moins l'une parmi les première à troisième antennes de détection ;
la réception du premier signal réfléchi par l'objet externe (30) par une antenne de détection, qui ne transmet pas le premier signal, par parmi les première à troisième antennes de détection ; et
l'obtention des informations sur un angle (a) formé par le module d'antenne et l'objet externe, sur la base du premier signal ainsi reçu.
